Europäisches Patentamt

European Patent Office

Office européen des brevets

(19)

(11) Publication number: **0 448 041 A1**

## EUROPEAN PATENT APPLICATION

(12)

(21) Application number: 91104239.8

(22) Date of filing: 19.03.91

(51) Int. Cl.⁵: H01L 31/107

(30) Priority: 20.03.90 JP 72349/90

(43) Date of publication of application:
25.09.91 Bulletin 91/39

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Mikawa, Takashi
2-3-1-407, Kamiyouga
Setagaya-ku, Tokyo, 158(JP)
Inventor: Kuwatsuka, Haruhiko
3929-12, Akuwacho, Seya-ku
Yokohama-shi, Kanagawa, 246(JP)

Inventor: Kito, Yasuhiro
2-3-10, Sakecho
Atsugi-shi, Kanagawa, 243(JP)
Inventor: Ito, Masanori
3-8-19-202, Minamida
Sagamihara-shi, Kanagawa, 228(JP)
Inventor: Yamakoshi, Shigenobu
3649-158, Kokubu
Ebina-shi, Kanagawa, 243-04(JP)

(74) Representative: Schmidt-Evers, Jürgen,
Dipl.-Ing. et al
Patentanwälte Mitscherlich, Gunschmann
Dr. Körber, Schmidt-Evers, Melzer, Dr. Schulz
Steinsdorfstrasse 10
W-8000 München 22(DE)

(54) Avalanche photodiodes.

(57) An avalanche photodiode includes a light absorbing layer (23) containing at least one impurity of a first conductivity type (n), a transition layer (24) formed on the light absorbing layer and having at least one impurity of the first conductivity type, and an electric field drop layer (25, 45) formed on the transition layer and having at least one impurity of the first conductivity type. The avalanche photodiode also includes a window layer (26) formed on the electric field drop layer and having a concentration lower than that of the electric field drop layer, and a light receiving region (28) formed in the window layer and having a depth so that a multiplication region (26a) which is a part of the window layer is formed between the electric field drop layer and the light receiving region. The light receiving region has at least one impulity of a second conductivity type (p) opposite to the first conductivity type. The amount of an electric field drop in the electric field drop layer and the length of the multiplication region are selected so that a curve showing a change in a gain bandwidth product of the avalanche photodiode as a function of the length of the multiplication region has a peak at which the gain bandwidth product is equal to or higher than a predetermined gain bandwidth product equal to, for example, approximately 40 GHz.

FIG.2

## FIG.3

GAIN BANDWIDTH PRODUCT (GHz)

C3(5.5×10⁵ V/cm)

C2(4.5×10⁵ V/cm)

CI(4.0×10⁵V/cm)

MULTIPLICATION REGION LENGTH La (μm)

2

## BACKGROUND OF THE INVENTION

The present invention generally relates to avalanche photodiodes, and more particularly to a so-called Lo-Hi-Lo (Low-High-Low) type avalanche photodiode having an electric field drop layer interleaved between a light absorbing layer and a multiplication layer.

There is a need for ultra-high-speed avalanche photodiodes in order to realize optical fiber communications of the order of 5 Gb/s. For this requirement, it is necessary to provide an avalanche photodiode having a frequency characteristic corresponding to a gain bandwidth product of at least 40 GHz.

A so-called Hi-Lo type avalanche photodiode is known as a ultra-high-speed avalanche photodiode capable of realizing a gain bandwidth product of the 10 GHz range. The Hi-Lo type avalanche photodiode has a multiplication region having a high impurity concentration (atoms/cm$^3$) higher than that of a light absorbing layer. However, the Hi-Lo type avalanche photodiode has a disadvantage in that the multiplication is liable to occur in the light absorbing layer and may increase in the light absorbing layer, depending on the position of a pn junction between a light receiving portion (p$^+$-type region) and the multiplication region. For these reasons, it is very difficult to reliably product the Hi-Lo type avalanche photodiodes.

A so-called Lo-Hi-Lo type avalanche photodiode is also known as a photodiode capable of realizing ultra-high-speed optical communications. The Lo-Hi-Lo type avalanche photodiode has an electric field drop layer having a high concentration which is interleaved between the light absorbing layer and the multiplication region which is a part of a window layer. This type of avalanche photodiode can be easily produced and provides a reduced carrier traveling time due to the existence of the electric field drop layer and a wide frequency characteristic, as compared with the Hi-Lo type avalanche photodiode.

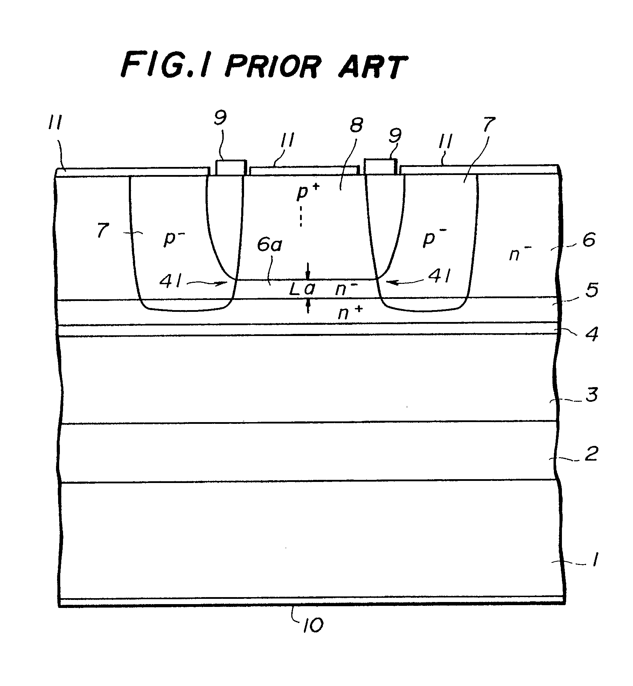

FIG.1 is a cross-sectional view of a conventional Lo-Hi-Lo type avalanche photodiode. As shown, the avalanche photodiode has an n-type InP substrate 1, an n-type InP buffer layer 2, an n-type light absorbing layer 3, an n-type InGaAsP transition layer 4, an n-type InP electric field drop layer 5, an n$^-$-type InP window layer 6, a p$^-$-type guard ring region 7, a p-type light receiving region 8, a p-type contact electrode 9, an n-type contact electrode 10, and a passivation layer 11. The basic structure of the Lo-Hi-Lo type avalanche photodiode is disclosed in USP 4,481,523, and the use of the guard ring region is disclosed in F. Kuroda et al., "HIGH SPEED APD WITH Mg GUARD RING", 1989 Autumn National Convention Record, The Institute of Electronics, Information and Communication Engineers, C-431, pp. 4-220.

The electric field drop layer 5 is doped with n-type impurities at a concentration higher than that of each of the other layers except the substrate 1, and reduces the electric field in the light absorbing layer 3. That is, the electric field drop layer 5 plays the important role of the operation of the ultra-high-speed avalanche photodiode.

When each of the light absorbing layer 3 and the window layer 6 has an n-type impurity concentration of approximately $5 \times 10^{15}$ cm$^{-3}$, the electric field drop layer 5 is formed so that it has a concentration of approximately $2 \times 10^{16}$ cm$^{-3}$ and a thickness of approximately 0.5 - 1.0 micrometers. The amount of the electric field drop obtained in this case is approximately $2.2 \times 10^5$ V/cm. The multiplication region 6a is approximately 0.5 - 1.5 micrometers thick (La).

The Lo-Hi-Lo type avalanche photodiode has an improved frequency characteristic, as compared with the Hi-Lo type avalanche photodiode. However, there is the limit of the gain bandwidth product equal to approximately 30 GHz. Thus, the Lo-Hi-Lo type avalanche photodiode cannot realize 5Gb/s range optical fiber communications.

## SUMMARY OF THE INVENTION

It is a general object of the present invention to provide an improved Lo-Hi-Lo type avalanche photodiode, in which the above-mentioned disadvantages are eliminated.

A more specific object of the present invention to provide an Lo-Hi-Lo type avalanche photodiode capable of realizing 5Gb/s range optical fiber communications.

The above-mentioned objects of the present invention are achieved by an avalanche photodiode comprising: a light absorbing layer containing at least one impurity of a first conductivity type; a transition layer formed on the light absorbing layer and having at least one impurity of the first conductivity type; an electric field drop layer formed on the transition layer and having at least one impurity of the first conductivity type; a window layer formed on the electric field drop layer and having a concentration lower than that of the electric field drop layer; and a light receiving region formed in the window layer and having a depth so that a multiplication region which is a part of the window layer is formed between the electric field drop layer and the light receiving region, the light receiving region having at least one impulity of a second conductivity type opposite to the first conductivity type. The electric field drop layer has an amount Ed (V/cm) of an electric field drop and the multiplication region has a length La (micrometer) so that the following is satisfied:

$$La \geq 44.8 - 3.47 \times 10^{-4}Ed + 1.02 \times 10^{-9}Ed^2 - 1.33 \times 10^{-15}Ed^3 + 6.50 \times 20^{-22}Ed^4,$$

and

$$La \leq 30.6 - 1.45 \times 10^{-4}Ed + 2.32 \times 10^{-10}Ed^2 - 1.26 \times 10^{-16}Ed^3.$$

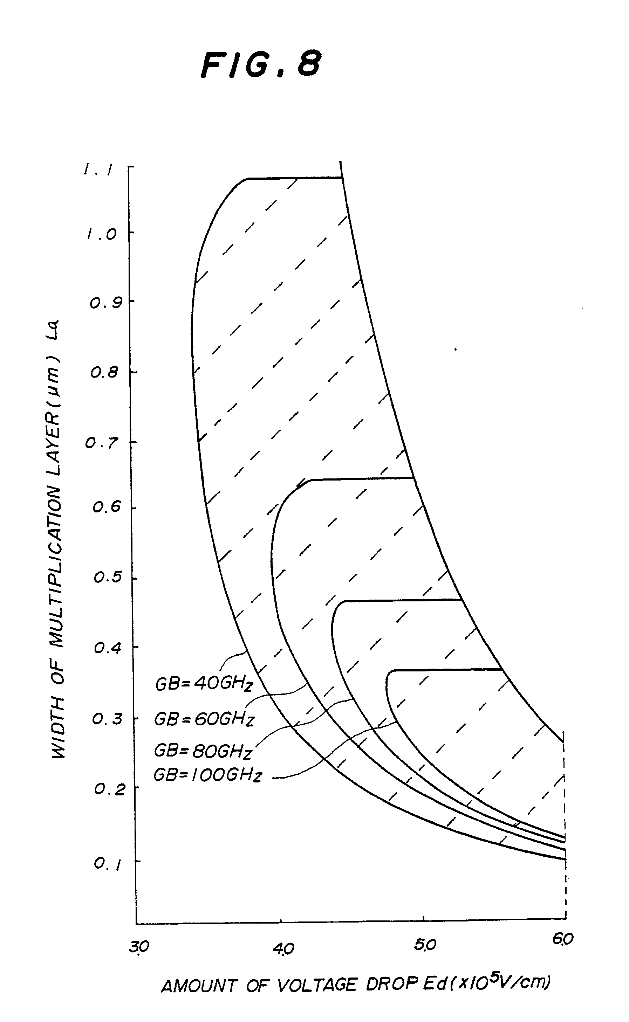

The above formulas were obtained by the present inventors through their various studies. The inventors found that in order to obtain a gain bandwidth product equal to or higher than 30 GHz in Lo-Hi-Lo type avalanche photodiodes, it is necessary to optimize the length La of the multiplication layer in the vertical direction (that is, the width thereof) and the amount Ed of the electric field drop in the electric field drop layer. A graph of FIG.8 shows the several relationships between the length La (micron meter) of the multiplication layer and the amount Ed (x $10^5$ V/cm) of the electric field drop layer. It can be seen from the graph that it is possible to obtain gain bandwidth products equal to higher than 40 GHz by the optimizing the relationship between the length La of the multiplication layer and the amount Ed of the electric field drop layer and such gain bandwidth products equal to or higher than 40 GHz are within an area hatched by broken lines. Thus, the present invention realizes an Lo-Hi-Lo type avalanche photodiode having a gain bandwidth product within the hatched area in FIG.8. This hatched area can be defined by the above-mentioned formulas.

The above-mentioned objects of the present invention are also achieved by forming the electric field drop layer and the multiplication region so that the electric field drop layer has an electric field drop equal to or higher than 4 x $10^5$ V/cm, and the multiplication region has a length equal to or less than 0.5 micrometers.

The aforementioned objects of the present invention are also achieved by forming the electric field drop layer and the multiplication region in such a way that an amount of an electric field drop in the electric field drop layer and a length of the multiplication region are selected so that a curve showing a change in a gain bandwidth product of the avalanche photodiode as a function of the length of the multiplication region has a peak at which the gain bandwidth product is equal to or higher than a predetermined gain bandwidth product.

## BRIEF DESCRIPTION OF THE DRAWINGS

The other objects, features and advantages of the present invention will become more apparent from the following detailed description when read in conjunction with the accompanying drawings, in which:

FIG.1 is a cross-sectional view of a conventional Lo-Hi-Lo type avalanche photodiode;

FIG.2 is a cross-sectional view of an avalanche photodiode according to a first preferred embodiment of the present invention;

FIG.3 is a graph illustrating the relationship between the gain bandwidth product and the length of a multiplication region in which the amount of the electric field drop occurring in an electric field drop layer is changed;

FIG.4 is an energy band diagram illustrating the function of a transition layer shown in FIG.2;

FIG.5 is a graph illustrating the relationships between the breakdown voltage and the concentration of the electric field drop layer according to the prior art and the present invention;

FIG.6A is a graph illustrating impurity profiles as a function of depth;

FIG.6B is a graph illustrating electric field profiles as a function of depth;

FIG.7 is a cross-sectional view of an avalanche photodiode according to a second preferred embodiment of the present invention; and

FIG.8 is a graph showing the relationships between the width of the multiplication region (length in the vertical direction) and the amount of the electric field drop layer.

## DESCRIPTION OF THE PREFERRED EMBODIMENTS

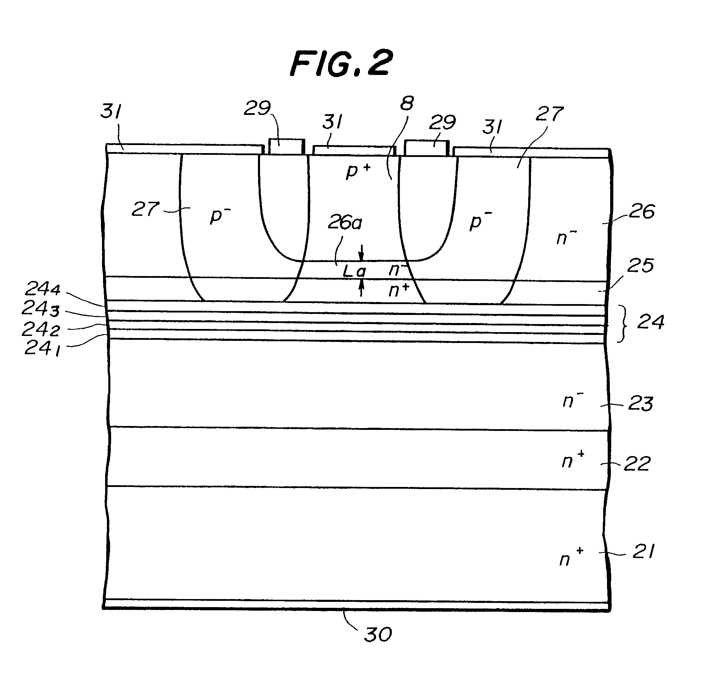

FIG.2 is a cross-sectional view of a Lo-Hi-Lo avalanche photodiode according to a first preferred embodiment of the present invention. The avalanche photodiode in FIG.2 has an $n^+$-type InP substrate 21, an $n^+$-type InP buffer layer 22, an $n^-$-type InGaAs light absorbing layer 23, an $n^-$-type InGaAsP transition layer 24, an $n^+$-type electric field drop layer 25, an $n^-$-type InP window layer 26, an $n^-$-type InP multiplication region 26a, a $p^-$-type guard ring region 27, a $p^+$-type region 28, a p-type contact region 29, an n-type contact region 30, and a passivation layer 31.

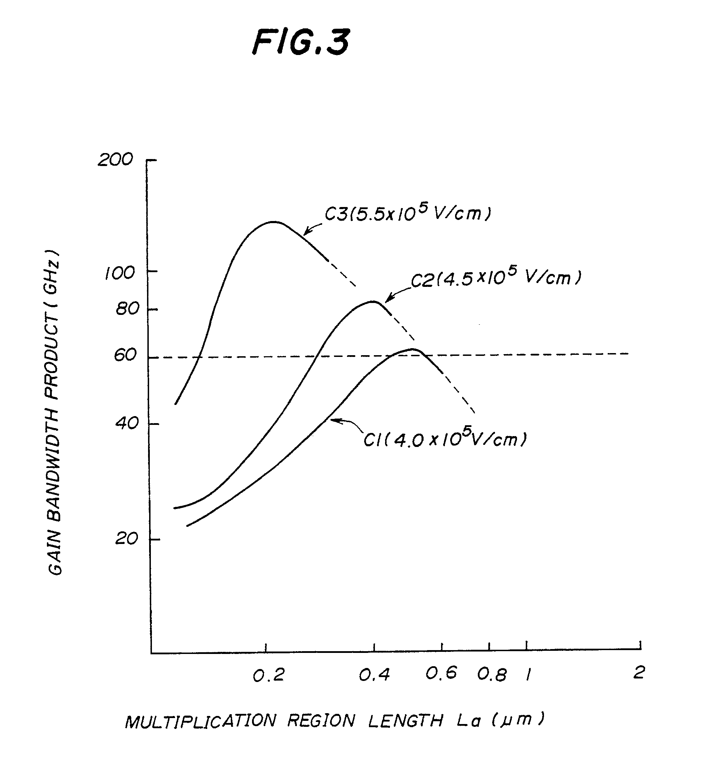

FIG.3 is a graph showing the relationships between the gain bandwidth product (GHz) and the length La of the multiplication region 26a measured in the vertical direction. Curve C1 shows a change in the gain bandwidth product as a function of the multiplication region length La obtained when the amount of the electric field drop in the electric field drop layer 25 is equal to 4.0 x $10^5$ V/cm. Curves C2 and C3 show changes obtained when the amounts of the electric field drop in the electric field drop layer 25 are equal to 4.5 x $10^5$ V/cm and

5.5 x 10⁵ V/cm, respectively.

It should be noted that the amount of the electric field drop in the electric field drop layer 25 is determined based on the thickness of the electric field drop layer 25 and the n-type impurity concentration thereof. For example, when the electric field drop layer 25 is 500 angstroms, the n-type impurity concentration of the electric field drop layer 25 is set equal to $5.5 \times 10^{17} cm^{-3}$ in order to obtain the amount of the electric field drop equal to $4.0 \times 10^5$ V/cm. For the same thickness of the electric field drop layer 25, the n-type impurity concentrations of the electric field drop layer 25 are set equal to $6.2 \times 10^{17} cm^{-3}$ and $7.5 \times 10^{17} cm^{-3}$ in order to obtain the amounts of the electric field drop equal to $4.5 \times 10^5$ V/cm and $5.5 \times 10^5$ V/cm.

It can be seen from the graph of FIG.3 that in the avalanche photodiode of the Lo-Hi-Lo type, there is the peak (peak frequency) of the maximum gain bandwidth product when the length La of the multiplication region 26a has a special value. This phenomenon inherent in the Lo-Hi-Lo type avalanche photodiodes was found by the present inventors. For example, when the amount of the electric field drop obtained in the electric field drop layer 25 is $4.0 \times 10^5$ V/cm and the length La of the multiplication region 26a is approximately 0.5 micrometers, a peak of the gain bandwidth product higher than 60 GHz can be obtained.

The simulation by the present inventors shows that it is preferable that the relationship between the amount of the electric field drop in the electric field drop layer 25 and the length La of the multiplication region 26a satisfies the following condition:

$$La \geq 44.8 - 3.47 \times 10^{-4} Ed + 1.02 \times 10^{-9} Ed^2 - 1.33 \times 10^{-15} Ed^3 + 6.50 \times 20^{-22} Ed^4,$$

and

$$La \leq 30.6 - 1.45 \times 10^{-4} Ed + 2.32 \times 10^{-10} Ed^2 - 1.26 \times 10^{-15} Ed^3$$

where La is the length ($\mu$m) of the multiplication region 26a, and Ed is the amount (V/cm) of the electric field drop in the electric field drop layer 25.

The layers of the avalanche photodiode shown in FIG.2 are formed, for example, as follows.

Substrate 21
Material: InP
Concentration: $1 \times 10^{18} cm^{-3}$ (n type)

Buffer layer 22
Material: InP
Concentration: $7.5 \times 10^{17} cm^{-3}$ (n type)

Thickness: 0.5 micrometers

Light absorbing layer 23
Material: InGaAs
Concentration: $5 \times 10^{15} cm^{-3}$ (n type)
Thickness: 1.5 micrometers

Transition layer 24
Material: InGaAsP
Number of layers: 4
Band gaps: 0.86eV, 0.93eV, 1.1eV and 1.24eV from the side of the light absorbing layer 23
Concentration: $5 \times 10^{15} cm^{-3}$ (n type)
Thickness: each 500 angstroms

Electric field drop layer 25
Material: InP
Concentration: $7.5 \times 10^{17} cm^{-3}$ (n type)
Thickness: 500 angstroms
Amount of electric field: $5.5 \times 10^5$ V/cm

Window layer 26
Material: InP
Concentration: $5 \times 10^{15} cm^{-3}$ (n type)
Thickness: 1.5 micrometers

Multiplication region 26a
Material: InP
Concentration: $5 \times 10^{15} cm^{-3}$ (n type)
Thickness: 0.2 micrometers

Guard ring region 27
Impurity: Be
Surface concentration: $1.5 \times 10^{17} cm^{-3}$
Junction position: an interface between the electric field drop layer 25 and the transition layer 24

$P^+$-type region 28
Impurity: Cd
Surface concentration: $2 \times 10^{18} cm^{-3}$

P contact region 29
Material: Alloy of Au/Zn/Au

N contact region 30
Material: alloy of AuGeNi

Passivation layer 31
Material: SiN
Thickness: 2000 angstroms

The above-mentioned layer structure can be formed by a MOCVD (Metal Organic Chemical Vapor Deposition) process. The guard ring region 27 can be formed by a Be ion implantation process, and the $p^+$-type region 28 can be formed by a Cd vapor diffusion process. The Lo-Hi-Lo type avalanche photodiode thus formed is packaged, for example, together with an optical element such as a lens. The avalanche photodiode according to the above-mentioned embodiment has the electric field drop layer 25 having a concentration of $7.5 \times 10^{17}$ $cm^{-3}$ and a thickness of 500 angstroms, which provide the amount of the electric field drop equal to approximately $5.5 \times 10^5$ V/cm. Further, the avalanche photodiode according to the above-mentioned embodiment has the multiplication region 26a which is 0.2 micrometers thick. Thus, it can be seen from the graph of FIG.3 that it is possible to obtain a gain bandwidth product higher than 100 GHz, which can realize 5Gb/s range optical fiber communications. In addition, since the present invention is of the Lo-Hi-Lo type, it is possible to reliably produce a large number of avalanche photodiodes.

It should be noted that the transition layer 24 is one of the essential features of the avalanche photodiode shown in FIG.2. As has been described previously, the transition layer 24 consists of four InGaAsP layers now labeled $24_1$, $24_2$, $24_3$ and $24_4$ from the light absorbing layer 23.

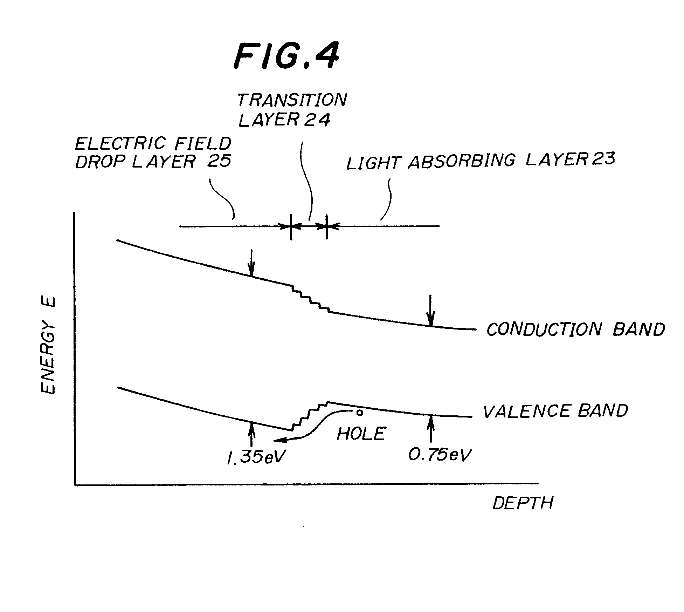

FIG.4 is an energy band diagram of the avalanche photodiode shown in FIG.2. It can be seen from the diagram of FIG.4 that the transition layer 24 functions to absorb the energy difference between the electric field drop layer 25 and the light absorbing layer 23. The energy band gap of the electric field drop layer 25 is equal to 1.35 eV, and the energy band gap of the light absorbing layer 23 is equal to 0.75 eV. The transition layer 24 has a stepwise energy band gap change. The energy band gap of the transition layer 24 can be changed by changing x and y of $In_xGa_{1-x}As_yP_{1-y}$ where x and y are respectively positive numbers. The stepwise change of the energy band gap makes it possible for holes generated in the light absorbing layer 23 to move toward the electric field drop layer 25 at a higher speed. We found that it is sufficient to absorb the energy band gap discontinuity between the electric field layer 25 and the light absorbing layer 23 by providing four InGaAsP layers. This means that more than four InGaAsP layers does not provide considerable advantages, as compared with the four InGaAsP layer structure.

The guard ring region 27 shown in FIG.2 is different from the conventional guard ring region 7 shown in FIG.1. More specifically, the breakdown voltage of the guard ring region 27 is higher than that of the guard ring region 7. As shown in FIG. 1, the bottom end of the conventional guard ring region 7 is positioned at an intermediate portion of the electric field drop layer 5. It will be noted that a breakdown is liable to occur at any of curved ends 41 of the p$^+$-type region 8 shown in FIG.1. The conventional guard ring region 7 is directed to covering the curved ends 41 of the p$^+$-type region 8 by the p$^-$ region. Thus, the position of the bottom end of the guard ring region 7 is not important in the conventional avalanche photodiode. In other words, no consideration is given to the bottom end of the guard ring region 7.

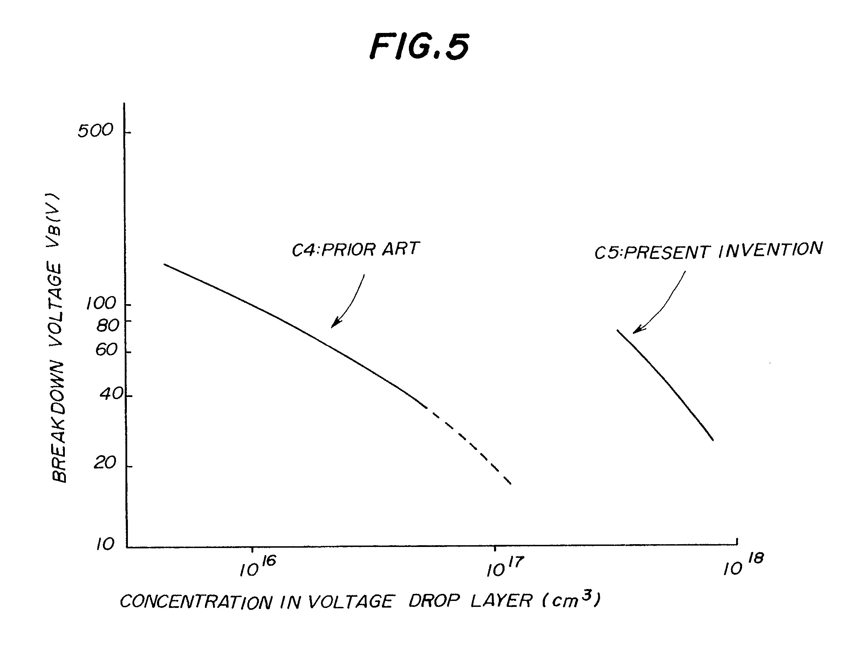

FIG.5 is a graph illustrating the relationship between the breakdown voltage $V_B$ (volt) and the concentration (atoms/cm$^3$) of the electric field drop layer. Curve C4 shows a change of the breakdown voltage $V_B$ of the conventional avalanche photodiode, and curve C5 shows a change of the breakdown voltage $V_B$ of the avalanche photodiode having the structure shown in FIG.2. It can be seen from the graph of FIG.5 that the breakdown voltage $V_B$ of the guard ring region 7 becomes less than 20 volts when the concentration of the electric field drop layer 5 becomes higher than $1 \times 10^{17}$ cm$^{-3}$. This case does not provide a sufficient breakdown voltage with respect to the p$^+$-type region 8.

On the other hand, the guard ring region 27 shown in FIG.2 has a bottom end in contact with the top of the transition layer 24. That is, the guard ring region 27 is formed in the entire depth of the electric field drop layer 25. With this arrangement, as can be seen from the curve C5, the breakdown voltage $V_B$ approximately equal to 30 volts can be obtained even when the concentration of the electric field drop layer 25 is set equal to approximately $7 \times 10^{17}$ cm$^{-3}$. The difference between the breakdown voltage of the prior art and the breakdown voltage of the present invention is equal to approximately 10 - 15 volts. Since the avalanche photodiodes, each having the electric field drop layer, can operate with small operation voltages, the above-mentioned difference is very effective.

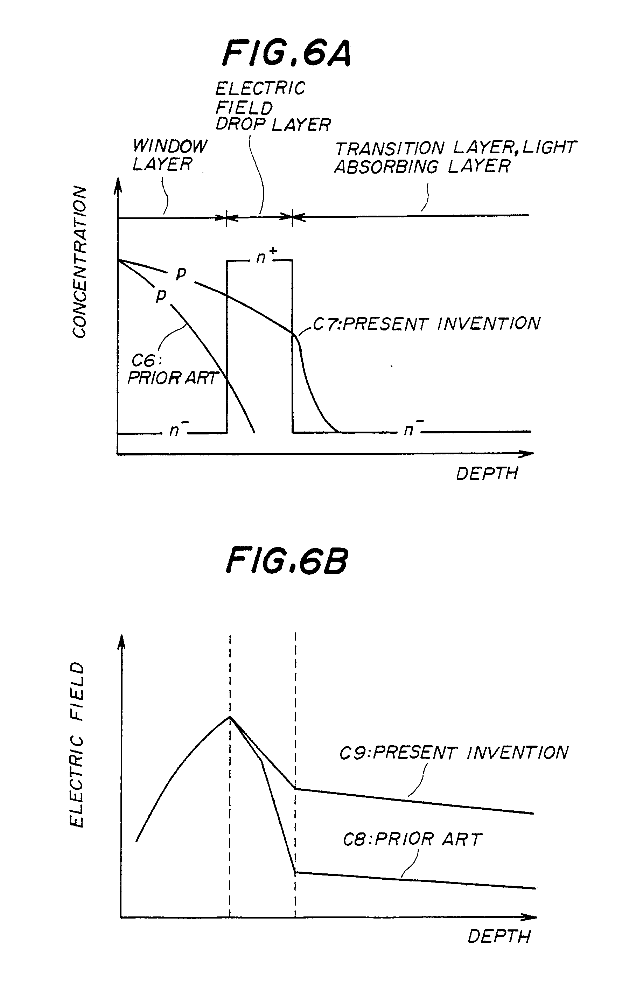

The increased breakdown voltage of the avalanche photodiode according to the present invention can be obtained by the following mechanism. FIG.6A is a graph illustrating profiles of the impurity concentration as a function of the depth, and FIG.6B is a graph illustrating profiles of the electric field as a function of the depth. In FIG.6A, curve C6 is a p-type impurity profile of the conventional shown in FIG.1, and curve C7 is a p-type impurity profile of the improved layer structure shown in FIG.2. In FIG.6B, curve C8 is an electric field profile of the conventional layer structure shown in FIG.1, and curve C9 is an electric field profile of the improved layer structure shown in FIG. 2.

As can be seen from FIG.6A, the p-type impurities of the guard ring region 7 shown by the curve C6 reach only an intermediate portion of the electric field drop layer 5. Thus, the electric field drop layer 5 is dominated by its the n-type impurities. On the other hand, the p-type impurities of the guard ring region 27 shown by the curve C7 are introduced in the entire depth of the electric field drop layer 25. Thus, the influence of the n-type impurities of the electric field drop layer 25 is relaxed by the existence of the p-type impurities of the guard ring region 27.

As can be seen from FIG.6B, the electric field of the conventional photodiode indicated by the curve C8 abruptly drops at the intermediate portion of the electric field drop layer 5 at which the concentration of the p-type impurities becomes substantially negligible. On the other hand, the electric field of the present invention indicated by the curve C9 is maintained at a high state due to the relaxation of the n-type impurities by the p-type impurities. It wall be noted that the breakdown voltage $V_B$ corresponds to an area inside of the electric field profile as a function of the depth. It can be seen from FIG.6B that the area inside of the curve C9 is wider than the area inside of the curve C8. It should be noted that the guard ring region 27 is very important since the electric field drop layer 25 has a high concentration to improve the gain bandwidth product.

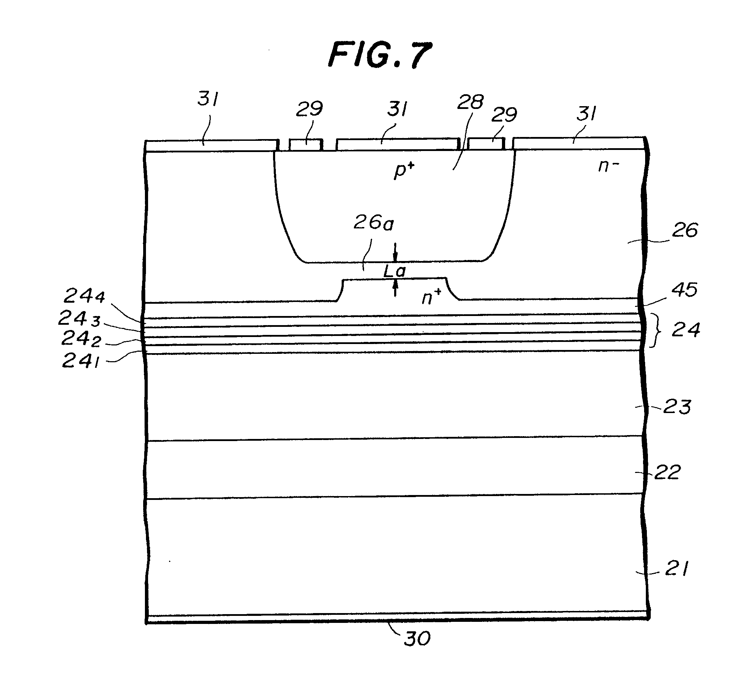

FIG.7 is a cross-sectional view of an avalanche photodiode according to a second preferred embodiment of the present invention. In FIG.7, those parts which are the same as those shown in FIG.2 are given the same reference numerals. The avalanche photodiode shown in FIG.7 is a Lo-Hi-Lo type avalanche photodiode having no guard ring region. The layer structure shown in FIG.7 can provide a sufficient breakdown voltage between the $p^+$-type region 28 and the window layer 26 without using the guard ring region. An electric field drop layer 45 has a projection which faces the $p^+$-type layer 28 and which is formed by etching. The electric field drop layer 45 has the amount of electric field equal to or higher than $4.0 \times 10^5$ V/cm, for example. The length La of the concentration layer 26a has a length equal to or less than 0.5 micrometers. More specifically, the amount of the electric field Ed and the length La of the multiplication region 26a are selected so as to have the aforementioned condition.

The present invention is not limited to the specifically disclosed embodiments, and variations and modifications may be made without departing from the scope of the present invention.

## Claims

1. An avalanche photodiode comprising:
   a light absorbing layer (23) containing at least one impurity of a first conductivity type;
   a transition layer (24) formed on said light absorbing layer and having at least one impurity of the first conductivity type (n);
   an electric field drop layer (25, 45) formed on said transition layer and having at least one impurity of the first conductivity type;
   a window layer (26) formed on said electric field drop layer and having a concentration lower than that of said electric field drop layer; and
   a light receiving region (28) formed in said window layer and having a depth so that a multiplication region (26a) which is a part of said window layer is formed between said electric field drop layer and said light receiving region, said light receiving region having at least one impulity of a second conductivity type (p) opposite to the first conductivity type,
   characterized in that said electric field drop layer (24, 45) has an amount Ed (V/cm) of an electric field drop and said multiplication region (26a) has a length La (micrometer) so that the following is satisfied:

   $$La \geq 44.8 - 3.47 \times 10^{-4}Ed + 1.02 \times 10^{-9}Ed^2 - 1.33 \times 10^{-15}Ed^3 + 6.50 \times 20^{-22}Ed^4,$$

   and

   $$La \leq 30.6 - 1.45 \times 10^{-4}Ed + 2.32 \times 10^{-10}Ed^2 - 1.26 \times 10^{-16}Ed^3.$$

2. An avalanche photodiode as claimed in claim 1, characterized by further comprising a guard ring region (27) extending in the entire depth of said window layer and the entire depth of said electric field drop layer and surrounding said light receiving region.

3. An avalanche photodiode as claimed in claim 2, characterized in that said guard ring region (27) comprises at least one impurity of the second conductivity type.

4. An avalanche photodiode as claimed in claim 2, characterized in that said guard ring region (27) has a bottom end surface which is in contact with a top of said transition layer.

5. An avalanche photodiode as claimed in claim 1, characterized in that:
   said transition layer (24) comprises a plurality of stepwise energy band gaps; and
   said stepwise energy band gaps stepwise increase toward said electric field drop layer from said light absorbing layer.

6. An avalanche photodiode as claimed in claim 5, characterized in that:
   said transition layer (24) comprises at least four stepwise energy band gaps.

7. An avalanche photodiode as claimed in claim 1, characterized in that:

said transition layer (24) comprises at least four stacked layers ($24_1$ - $24_4$) having mutually different energy band gaps; and

said mutually different energy band gaps of said four stacked layers stepwise increase toward said electric field drop layer from said light absorbing layer.

8. An avalanche photodiode as claimed in any of claims 1 to 7, said electric field drop layer (25) comprises a substantially flat top surface opposite to said light receiving region.

9. An avalanche photodiode as claimed in any of claims 1 to 7, characterized in that said electric field drop layer (45) comprises a projection opposite to said light receiving region.

10. An avalanche photodiode as claimed in any of claims 1 to 9, characterized in that:

said light absorbing layer comprises InGaAs;

said transition layer comprises InGaAsP;

said electric field drop layer comprises InP; and

said window layer comprises InP.

11. An avalanche photodiode comprising:

a light absorbing layer (23) containing at least one impurity of a first conductivity type;

a transition layer (24) formed on said light absorbing layer and having at least one impurity of the first conductivity type (n);

an electric field drop layer (25, 45) formed on said transition layer and having at least one impurity of the first conductivity type;

a window layer (26) formed on said electric field drop layer and having a concentration lower than that of said electric field drop layer; and

a light receiving region (28) formed in said window layer and having a depth so that a multiplication region (26a) which is a part of said window layer is formed between said electric field drop layer and said light receiving region, said light receiving region having at least one impulity of a second conductivity type (p) opposite to the first conductivity type,

characterized in that said electric field drop layer has an electric field drop equal to or higher than $4 \times 10^5$ V/cm, and said multiplication region has a length equal to or less than 0.5 micrometers.

12. An avalanche photodiode comprising:

a light absorbing layer (23) containing at least one impurity of a first conductivity type;

a transition layer (24) formed on said light absorbing layer and having at least one impurity of the first conductivity type (n);

an electric field drop layer (25, 45) formed on said transition layer and having at least one impurity of the first conductivity type;

a window layer (26) formed on said electric field drop layer and having a concentration lower than that of said electric field drop layer; and

a light receiving region (28) formed in said window layer and having a depth so that a multiplication region (26a) which is a part of said window layer is formed between said electric field drop layer and said light receiving region, said light receiving region having at least one impulity of a second conductivity type (p) opposite to said first conductivity type,

characterized in that an amount of an electric field drop in said electric field drop layer and a length of said multiplication region are selected so that a curve showing a change in a gain bandwidth product of said avalanche photodiode as a function of the length of said multiplication region has a peak at which the gain bandwidth product is equal to or higher than a predetermined gain bandwidth product.

13. An avalanche photodiode as claimed in claim 12, characterized in that said predetermined gain bandwidth product is approximately equal to 40 GHz.

14. An avalanche photodiode as claimed in claim 12 or claim 13, characterized in that:

said transition layer comprises at least four stacked layers ($24_1$ - $24_4$) having mutually different energy band gaps; and

said mutually different energy band gaps of said four stacked layers stepwise increase toward said electric field drop layer from said light absorbing layer.

15. An avalanche photodiode as claimed in any of claims 12 - 14, characterized in that:

said avalanche photodiode comprises a guard ring region (27) extending in the entire depth of said window layer and the entire depth of said electric field drop layer and surrounding said light receiving region;

said guard ring region comprises at least one impurity of the second conductivity type; and

said guard ring region has a bottom end surface which is in contact with a top of said transition layer.

16. An avalanche photodiode as claimed in any of claims 12 - 15, characterized in that:

said light absorbing layer comprises In-GaAs;

said transition layer comprises InGaAsP;

said electric field drop layer comprises InP;

and

said window layer comprises InP.

# FIG.1 PRIOR ART

EP 0 448 041 A1

# FIG.2

# FIG.3

MULTIPLICATION REGION LENGTH La ($\mu$m)

# FIG.4

TRANSITION LAYER 24

ELECTRIC FIELD DROP LAYER 25

LIGHT ABSORBING LAYER 23

ENERGY E

CONDUCTION BAND

VALENCE BAND

HOLE

1.35eV

0.75eV

DEPTH

EP 0 448 041 A1

# FIG.5

EP 0 448 041 A1

# FIG.6A

# FIG.6B

FIG.7

# FIG.8

# DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | ELECTRONICS LETTERS. vol. 20, no. 15, 19 July 1984, ENAGE GB pages 635 - 637; F.Capasso et al.: "Low-dark-current low-voltage 1.3-1.6 micrometer avalanche photodiode with high-low electric field profile ..." * the whole document * | 1,11 | H 01 L 31/107 |
| X,Y | US-A-4 587 544 (P.P.WEBB) * column 2, line 6 - column 4, line 14; figures 1-4 * | 1,5-8,10, 11,2-4,9, 14 | |
| X,Y | Proc. IEEE Int.Conf. on Communications (Philadelphia, PA, U.S.) 12-15 June 1988 pages 306 - 312; I.Mito et al.: "High speed single frequency laser diodes and wide bandwidth detectors for multi-Gb/s fiber optic communication systems" * page 309; figures 9-10 * | 12-13,16, 14-15 | |
| Y | WO-A-9 001 217 (BRITISH TELECOM) * pages 3 - 4; figure 1 * | 2-4,15 | |
| Y,A | ELECTRONICS LETTERS. vol. 20, no. 4, 16 February 1984, ENAGE GB pages 158 - 159; K.Yasuda et al.: "InP/InGaAs buried-structure avalanche photodiodes" * the whole document * | 9,1, 10-12,16 | TECHNICAL FIELDS SEARCHED (Int. Cl.5) H 01 L |
| A | ELECTRONICS LETTERS. vol. 21, no. 20, 26 September 1985, ENAGE GB pages 886 - 887; W.S.Holden et al.: "Improved frequency response of InP/InGaAsP/InGaAs avalanche photodiodes with separate absorption, grading and multiplication ..." * the whole document * | 1,10-13 | |
| D,A | US-A-4 481 523 (F.OSAKA ET AL.) * the whole document * | 1-16 | |

The present search report has been drawn up for all claims

| Place of search | Date of completion of search | Examiner |
|---|---|---|
| Berlin | 26 June 91 | MUNNIX S J G |

CATEGORY OF CITED DOCUMENTS
X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

& : member of the same patent family, corresponding document